# EUROPEAN PATENT APPLICATION

(11) **EP 3 030 057 A1**
(43) Date of publication of application: **08.06.2016**
(21) Application number: 15197219.7
(22) Date of filing: 01.12.2015
(51) Int. Cl.: H05K 1/02, H05K 1/11

(54) **CIRCUIT BOARD AND ELECTRONIC KEY USING SAME**

(30) Priority: 02.12.2014 JP 2014243927
(71) Applicant: KABUSHIKI KAISHA TOKAI RIKA DENKI SEISAKUSHO, Niwa-gun, Aichi 480-0195 (JP)
(72) Inventor: SENZAKI, Daisuke, Aichi, 480-0195 (JP); KONO, Yuki, Aichi, 480-0195 (JP); KAWAMURA, Masayuki, Aichi, 480-0195 (JP); KOJIMA, Hiroaki, Aichi, 480-0195 (JP)
(74) Representative: Betten & Resch

(57) **Abstract**

A circuit board includes a circuit board pattern forming a part of an electronic circuit and including a mounting pattern group on which a receiving means for receiving an operation can be mounted. The electronic circuit is established even when the receiving means is mounted on any mounting pattern of the mounting pattern group.

## Description

The present application is based on Japanese patent application No.2014-243927 filed on December 2, 2014**,** the entire contents of which are incorporated herein by reference.

### BACKGROUND OF THE INVENTION

### 1. FIELD OF THE INVENTION

The invention relates to a circuit board and an electronic key using the circuit board.

### 2. RELATED ART

A mobile device for an electronic key system is provided with a case which forms the outline of a main body of the mobile device and encloses a circuit board mounting a communication circuit for wirelessly communicating with an external device, a protective cover placed over one side of the circuit board, and a plate-shaped battery holder placed over the other side of the circuit board to hold a battery (see e.g., JP-A-2008-196194**).**

### SUMMARY OF THE INVENTION

The mobile device may have a problem that according to a change in the design of the mobile device, a circuit board pattern thereof needs to be newly designed and evaluated based on the position of switch or high-frequency characteristics such as wiring, whereby the manufacturing cost increases.

It is an object of the invention to provide a circuit board that is flexibly adaptable to any change in the design of the mobile device, as well as an electronic key using the circuit board.

According to an embodiment of the invention, a circuit board comprises a circuit board pattern forming a part of an electronic circuit and comprising a mounting pattern group on which a receiving means for receiving an operation can be mounted,
wherein the electronic circuit is established even when the receiving means is mounted on any mounting pattern of the mounting pattern group.

### Effects of the invention

According to an embodiment of the invention, a circuit board can be provided that is flexibly adaptable to any change in the design of the mobile device, as well as an electronic key using the circuit board.

### BRIEF DESCRIPTION OF THE DRAWINGS

Next, the present invention will be explained in more detail in conjunction with appended drawings, wherein:
**FIG1** is an exploded perspective view showing an electronic key which uses a circuit board in an embodiment;
**FIG.2A** is a top view showing the circuit board in the embodiment;
**FIG.2B** is a bottom view showing the circuit board;
**FIG.2C** is an illustration diagram showing connection between a switch SW and a control circuit;
**FIG2D** is an illustration diagram showing connection between a switch SW1 and a switch SW2 in a module;
**FIG.3A** is a top view showing a housing of the electronic key in the embodiment;
**FIG.3B** is a cross sectional view taken along a line III(b)-III(b) in **FIG.3A** and viewed in an arrow direction;
**FIG.3C** is a bottom view showing the housing;
**FIG3D** is a side view taken from a left side through which a battery is inserted;
**FIG.3E** is a perspective view showing a control circuit unit and a battery terminal which are housed in a battery housing portion;
**FIG.3F** is a cross sectional view taken along a line III(f)-III(f) in **FIG.3C** and viewed in an arrow direction;
**FIGS.4A** to **4H** are illustration diagrams showing arrangement examples of switches; and
**FIGS.5A** to **5E** are illustration diagrams showing examples of electronic keys with different designs;
**FIG.5F** is an illustration diagram showing a modification of a circuit board pattern on the circuit board;
**FIG.5G** is a top view showing another modification of the circuit board pattern; and
**FIG.5H** is a cross sectional view showing the main portion of a dome-shaped cover arranged on the circuit board.

### DETAILED DESCRIPTION OF THE PREFERRED EMBODIMENTS

### Summary of embodiments

A circuit board of the embodiment has a circuit board pattern constituting part of an electronic circuit and having mounting pattern groups on which a receiving means for receiving an operation can be mounted, and the circuit board is configured so that the electronic circuit is established whichever mounting pattern of the mounting pattern group mounts the receiving means.

This circuit board has the mounting pattern groups on which a receiving means can be mounted, in a such a way that a mounting pattern corresponding to a desired design can be selected from the mounting pattern groups and the receiving means can be mounted on the selected mounting pattern. Therefore, the circuit board is flexibly adaptable to any change in the design, unlike the case of changing the mounting position of the receiving means and the position of wiring according to the change in the design.

### Embodiments

### General configuration of electronic key 1

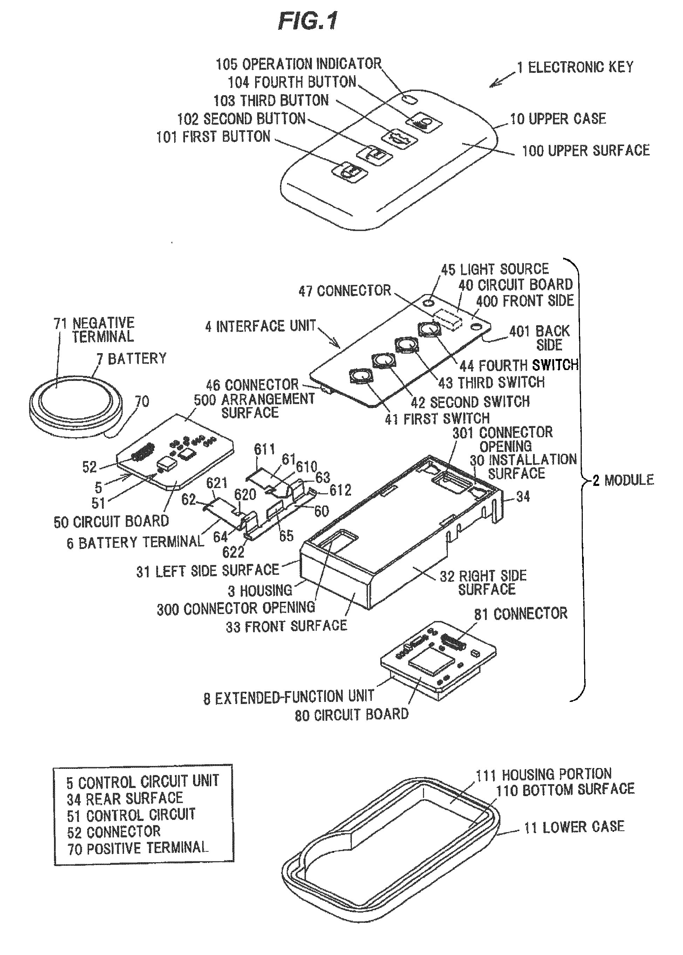

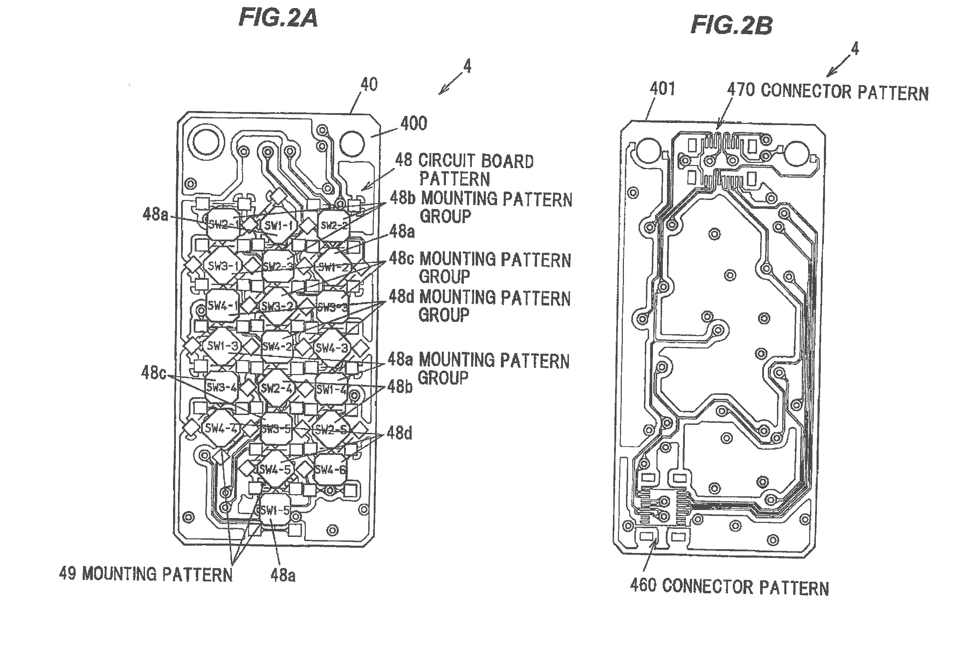

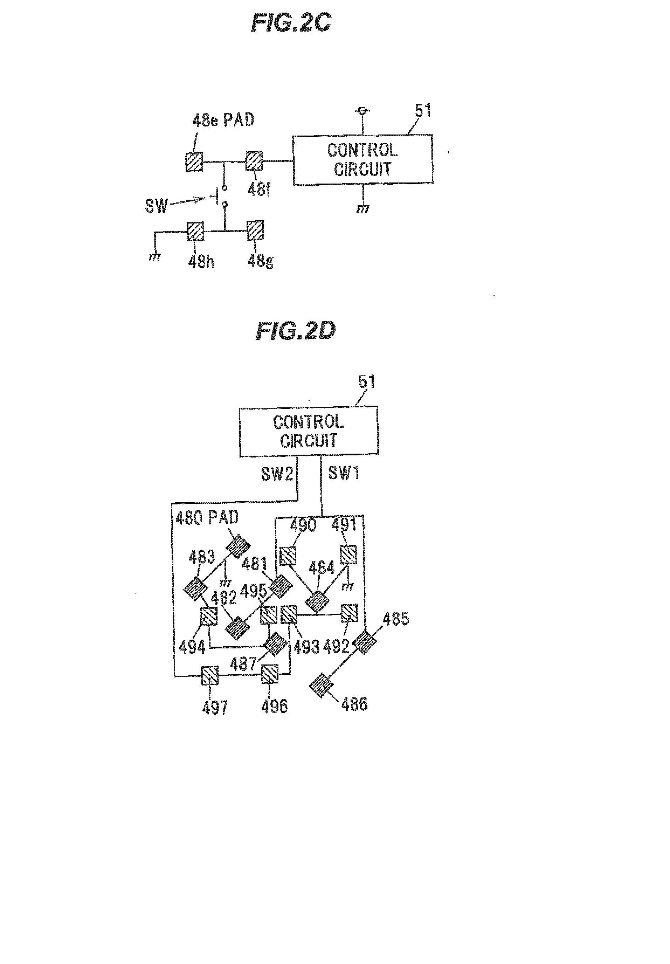

**FIG1** is an exploded perspective view showing an electronic key which uses a circuit board in the embodiment. **FIG.2A** is a top view showing the circuit board in the embodiment, **FIG.2B** is a bottom view showing the circuit board, **FIG.2C** is an explanatory schematic diagram illustrating connection between a switch SW and a control circuit and **FIG.2D** is an explanatory schematic diagram illustrating connection between a switch **SW1** and a switch **SW2** in a module. A scale ratio in each drawing of the embodiment may be different from the actual scale ratio.

An electronic key **1** is a mobile device capable of wirelessly instructing, e.g., locking/unlocking of vehicle doors and engine starting, etc. The electronic key **1** in the present embodiment bi-directionally communicates with a vehicle for ID authentication, and a person bringing the electronic key **1** can, e.g., lock/unlock vehicle doors when authenticated.

The electronic key **1** has first to fourth buttons **101** to **104** arranged on an upper surface **100** of an upper case **10,** as shown in **FIG.1****.** The first to fourth buttons **101** to **104** are configured to be push-operable.

The upper case **10** is formed to be integrated with a lower case **11.** The electronic key **1** is configured so that the upper case **10** and the lower case **11** house a module **2,** as shown in **FIG.1****.**

The module **2** is provided with a housing **3,** an interface unit **4,** a control circuit unit **5,** a battery terminal **6** and a battery **7.** Then, the interface unit **4** is provided with a circuit board **40.**

The circuit board **40** has a circuit board pattern **48** constituting part of an electronic circuit and having mounting pattern groups on which a receiving means for receiving an operation can be mounted, and the circuit board **40** is configured so that the electronic circuit is established whichever mounting pattern **49** of the mounting pattern group mounts the receiving means.

The mounting pattern groups are, e.g., a mounting pattern group **48a** having SW**1-1** to SW**1-5** as the mounting patterns **49,** a mounting pattern group **48b** having SW**2-1** to SW**2-5** as the mounting patterns **49,** a mounting pattern group **48c** having SW**3-1** to SW**3-5** as the mounting patterns **49,** and a mounting pattern group **48d** having SW**4-1** to SW**4-6** as the mounting patterns **49,** as shown in **FIG.2A**

A device using the module **2** is not limited to the electronic key **1** and the module **2** may be used in a mobile device which is capable of locking/unlocking a front door of a house or remotely operating an electronic device.

### Configuration of upper case 10 and lower case 11

The upper case **10** and the lower case **11** are formed of, e.g., a synthetic resin such as ABS (acrylonitrile butadiene styrene copolymer) resin or PC (polycarbonate) resin.

In addition to the first to fourth buttons **101** to **104,** for example, an operation indicator **105** is arranged on the upper case **10.** The first to fourth buttons **101** to **104** are configured to turn on first to fourth switches **41** to **44** of the module **2** based on the performed push-operation. Meanwhile, the operation indicator **105** emits light from a light source **45** of the module **2** (described later) when receiving the push-operation. An operator can know the reception of the operation by checking the light emitted from the operation indicator **105.**

As shown in **FIG1****,** a housing portion **111** having a shape corresponding to the shape of the module **2** is provided on a bottom surface **110** inside the lower case **11.** The housing portion **111,** together with the upper case **10,** houses and holds the module **2.** A recess which fits the shape of the battery **7** incorporated in the module **2** is formed on the housing portion **111.** The battery **7** is a button cell and has a disc shape. The battery **7** has a positive terminal **70** at the upper portion and a negative terminal **71** at the lower portion having a smaller radius than the positive terminal **70.**

The battery **7** is not limited to a button cell and may be a rechargeable battery as a modification. In case of using a rechargeable battery, the electronic key **1** is additionally provided with, e.g., an extended-function unit **8** (described later) allowing wireless charging of the rechargeable battery or an extended-function unit **8** allowing charging of the rechargeable battery through a cable.

The electronic key **1** may have a structure to incorporate a physical key as a backup in case that the module **2** cannot communicate with a vehicle. The physical key is arranged, e.g., between the housing portion **111** and the upper and lower cases **10, 11.**

### Configuration of module 2

The module **2** is provided with the extended-function unit **8,** in addition to the components mentioned above. The interface unit **4,** the control circuit unit **5,** the battery terminal **6,** the battery **7** and the extended-function unit **8** of the module **2** are integrally housed in the housing **3.**

The electronic key **1** can, e.g., lock/unlock doors based on the operation of a button when the extended-function unit **8** is not incorporated in the module **2.** When the extended-function unit **8** is incorporated in the module **2,** a function of the electronic key **1** is extended to allow an operator to, e.g., lock/unlock doors only by coming close to a vehicle or by touching the door.

### Configuration of housing 3

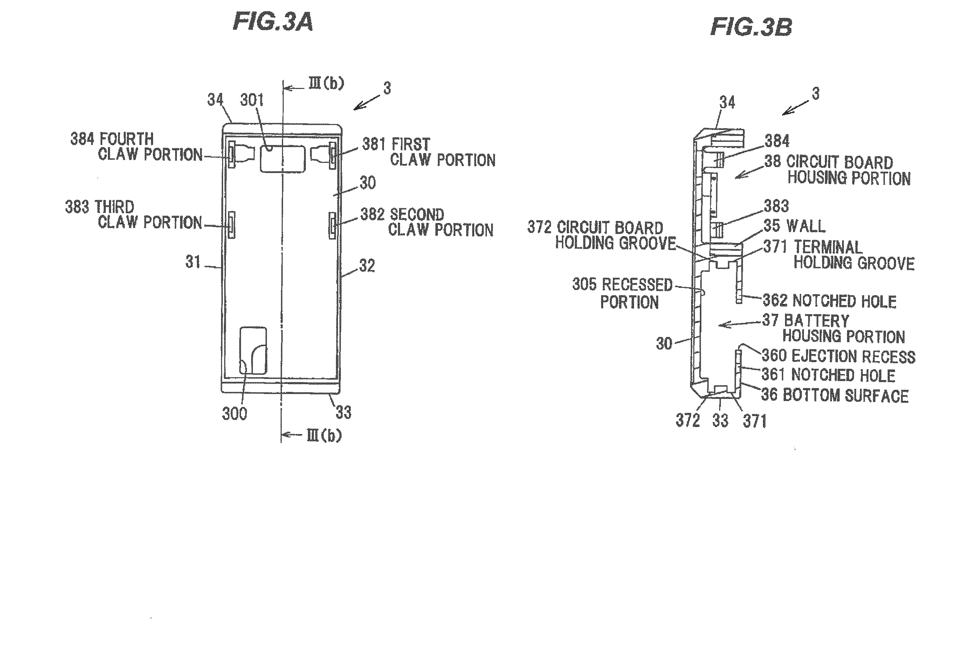

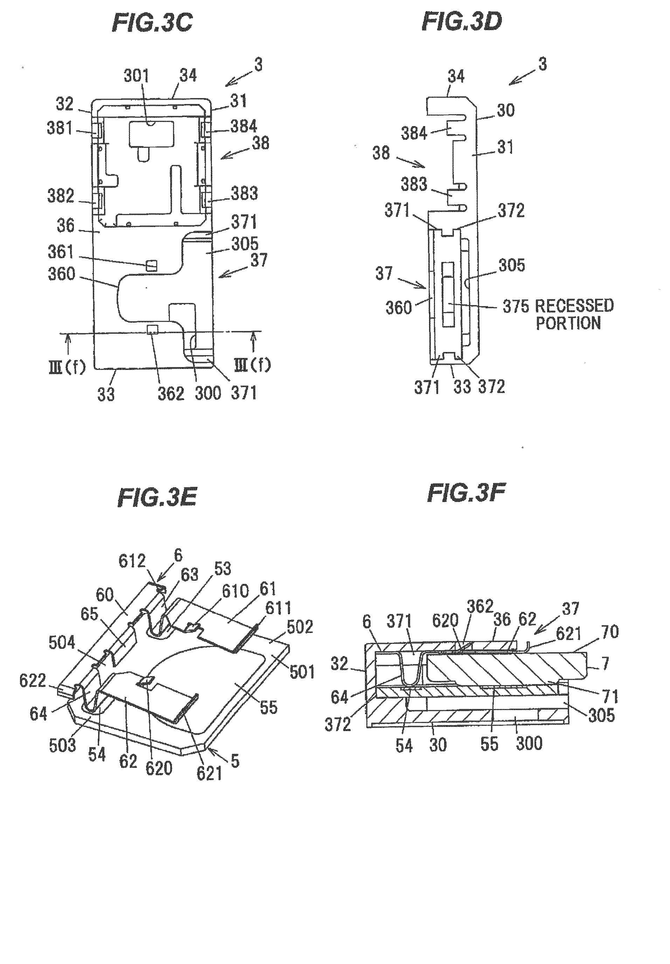

**FIG.3A** is a top view showing a housing of the electronic key in the embodiment, **FIG.3B** is a cross sectional view taken on line III(b)-III(b) of **FIG.3A** when viewed in an arrow direction, **FIG.3C** is a bottom view showing the housing, **FIG.3D** is a side view when viewed from the left side from which a battery is inserted, **FIG.3E** is a perspective view showing a control circuit unit and a battery terminal which are housed in a battery housing portion and **FIG.3F** is a cross sectional view taken on line III(f)-III(f) of **FIG.3C** when viewed in an arrow direction.

The housing **3** is formed of, e.g., a synthetic resin such as ABS resin or PC resin. The housing **3** has an installation surface **30** as a rectangular indent on the upper surface as shown in **FIGS.1** and **3A****,** and the interface unit **4** is arranged on the installation surface **30.**

The housing **3** has a circuit board housing portion **38** for housing the extended-function unit **8** which has a different function from that of the first to fourth switches **41** to **44.**

In detail, as shown in **FIG.3B****,** the housing **3** is divided by a wall **35** in such a way that a battery housing portion **37** is provided on a front surface **33** side and the circuit board housing portion **38** on the rear surface **34** side.

The housing **3** also has a connector opening **300** open on the battery housing portion **37** and a connector opening **301** open on the circuit board housing portion **38.**

The connector openings **300** and **301** have a rectangular shape and are provided on the installation surface **30.** The connector openings **300** and **301** are arranged so that, e.g., an angle formed between each other's longitudinal directions is **90°.**

As shown in **FIGS.3D** and **3F****,** the battery housing portion **37** is open on a left side surface **31,** and has terminal holding grooves **371** for guiding insertion of the battery terminal **6** and circuit board holding groove **372** for guiding insertion of a circuit board **50** which are provided on facing side surfaces. The facing side surfaces are a side surface on the wall **35** side and a side surface on the front surface **33** side inside the battery housing portion **37.**

In addition, in the battery housing portion **37,** a recessed portion **305** for housing a connector **52,** etc., arranged on the circuit board **50** is provided on the installation surface **30** side and a recessed portion **375** corresponding to the outer shape of the battery **7** is provided on a right side surface **32** side.

An ejection recess **360** recessed along an ejection direction of the battery **7** is formed on a bottom surface **36** of the battery housing portion **37** to facilitate ejection of the battery **7** housed in the battery housing portion **37.** As shown in **FIG.3C****,** rectangular notched holes **361** and **362** are formed on both sides of the ejection recess **360.** The notched holes **361** and **362** are provided so that protruding portions **610** and **620** of the battery terminal **6** (described later) are fitted thereto when the battery **7** is housed in the battery housing portion **37.** The battery terminal **6** is prevented from slipping out of the battery housing portion **37** by fitting the protruding portions **610** and **620** to the notched holes **361** and **362.**

The connector opening **300** is provided on the battery housing portion **37,** and the connector **52** of the circuit board **50** of the control circuit unit **5** (described later) is connected to a connector **46** of the interface unit **4** through the connector opening **300.**

A circuit board **80** of the extended-function unit **8** is housed in the circuit board housing portion **38.** On the circuit board housing portion **38,** first to fourth claw portions **381** to **384** are provided in a clockwise direction in the plane of **FIG.3A****.** The first claw portion **381** and the second claw portion **382** are arranged side by side, and so are the third claw portion **383** and the fourth claw portion **384.** The first claw portion **381** faces the fourth claw portion **384** and the second claw portion **382** faces the third claw portion **383.** The side portion of the circuit board **80** is fitted to the first to fourth claw portions **381** to **384** which thereby hold the circuit board **80.**

The connector opening **301** is provided on the circuit board housing portion **38,** and a connector **81** of the circuit board **80** is connected to a connector **47** of the interface unit **4** through the connector opening **301.**

### Configuration of interface unit 4

The interface unit **4** is composed of, e.g., receiving means for receiving an operation by an operator and an indicating means for indicating the reception of the operation. In detail, the interface unit **4** has, e.g., a light source, a switch, a touch sensor, a display, a microphone, a speaker, a camera and a solar cell panel, etc. The receiving means in the present embodiment is the first to fourth switches **41** to **44,** as an example.

The interface unit **4** is further provided with, e.g., the light source **45** on a front side **400** of the circuit board **40.** In addition, the interface unit **4** is provided with the connectors **46** and **47** on a back side **401** of the circuit board **40.**

The circuit board **40** of the interface unit **4** is, e.g., a long, rectangular printed circuit board, as shown in **FIGS.2A** and **2B****.** The circuit board **40** has a shape corresponding to the shape of the installation surface **30** of the housing **3.**

The first to fourth switches **41** to **44** are, e.g., surface-mounted microswitches. The first to fourth switches **41** to **44** are arranged in line so as to correspond to the arrangement of the first to fourth buttons **101** to **104** on the upper case **10.**

The first switch **41** is turned on by push-operation on the first button **101** and, as an example, doors of a vehicle are locked. The second switch **42** is turned on by push-operation on the second button **102** and, as an example, the doors of the vehicle are unlocked. The third switch **43** is turned on by push-operation on the third button **103** and, as an example, the trunk of the vehicle opens. The fourth switch **44** is turned on by push-operation on the fourth button **104** and, as an example, the alarm of the vehicle is armed.

Switch signals output from the first to fourth switches **41** to **44** are sent to, e.g., the control circuit unit **5** via the connector **46.** According to the input switch signal, the control circuit unit **5** generates a transmission signal to be sent to the vehicle and wirelessly outputs the generated transmission signal to the vehicle.

The light source **45** is constructed from, e.g., a light-emitting element. When the first to fourth switches **41** to **44** are turned on, the light source **45** receives power from the battery **7** via the connectors **52** and **46** and emits light.

Next, the circuit board pattern **48** formed on the circuit board **40** of the interface unit **4** will be described below.

As shown in **FIG.2A****,** the circuit board **40** has the circuit board pattern **48** on which plural switches SW can be arranged. The circuit board pattern **48** is configured that, e.g., four switches SW can be mounted.

As shown in **FIG.2C****,** the switch SW is electrically connected to, e.g., pads **48e** to 48h. The pads **48e** and **48f,** which are electrically connected to one terminal of the switch SW, are electrically connected to each other and are also electrically connected to a control circuit **51.** Meanwhile, the pads **48g** and **48h,** which are electrically connected to the other terminal of the switch SW, are electrically connected to each other and are also grounded. Depression of a button corresponding to the switch SW electrically connects the pads **48e, 48f** to the pads **48g, 48h.**

As shown in **FIG.2A****,** the circuit board pattern **48** not only simply allows four switches SW**1** to SW**4** to be arranged thereon, but also allows the switch SW**1** to be arranged on any one of the mounting patterns **49** indicated as SW**1-1** to SW**1-5** of the mounting pattern group **48a,** the switch **SW2** to be arranged on any one of the mounting patterns **49** indicated as SW**2-1** to SW**2-5** of the mounting pattern group **48b,** the switch SW3 to be arranged on any one of the mounting patterns **49** indicated as SW**3-1** to SW**3-5** of the mounting pattern group **48c,** and the switch SW**4** to be arranged on any one of the mounting patterns **49** indicated as **SW4-1** to SW**4-6** of the mounting pattern group **48d.**

In detail, the circuit board pattern **48** allows each switch to be arranged on any mounting pattern **49** without changing the wiring or the positions of the pads to be connected to the switch. In other words, the switch SW**1** is arranged on any one of the mounting patterns **49** (SW**1-1** to SW**1-5**) shown in **FIG.2A****.** The switch SW**2** is arranged on any one of the mounting patterns **49** (SW**2-1** to SW**2-5**) shown in **FIG.2A****.** The switch SW3 is arranged on any one of the mounting patterns **49** (SW**3-1** to SW**3-5**) shown in **FIG.2A****.** The switch SW**4** is arranged on any one of the mounting patterns **49** (SW**4-1** to SW4-6) shown in **FIG.2A****.**

Next, an example of electrical connection between the mounting patterns **49** (SW1-1, SW**1-2**, SW**2-2** and SW**2-3)** shown in **FIG.2D** will be described.

The circuit board pattern **48** is configured such that that one pad (or terminal, e.g., pads 481, 482, 485 and 486 in FIG.2D connected to the control circuit 51) of the mounting pattern **49** belonging to a mounting pattern group may be shared (or commonly used) and another pad (or terminal, e.g., pads 490, 491, 484, 487, 494 and 495 in FIG.2D grounded) of the mounting pattern **49** belonging to a different mounting pattern group may be shared (or commonly used).

In detail, SW**1-1** has pads **480** to **483.** SW**1-2** has pads **484** to **487.** SW**2-2** has pads **490** to **493.** SW**2-3** has pads **494** to **497.**

The pads **480, 483, 487, 494** and **495** are electrically connected to each other and are also grounded. The pads **481** and **482** are electrically connected to each other and are also electrically connected to the control circuit **51.** The pads **485** and **486** are electrically connected to each other and are also electrically connected to the control circuit 51.

The pads **484, 490** and **491** are electrically connected to each other and are also grounded. The pads **492, 493, 496** and **497** are electrically connected to each other and are also electrically connected to the control circuit **51.**

Since the pads of SW**1-1**, SW**1-2**, SW**2-2** and SW**2-3** are connected as described above, for example, the switch SW**1** can be arranged on SW**1-1** or SW**1-2** and the switch SW**2** on SW**2-2** or SW**2-3**.

Here, the switches arranged on the circuit board pattern **48** may be at least one of the four switches. In addition, since the control circuit **51** determines SW**1** to SW **4**, the switch can be arranged on the mounting pattern **49** for any of SW**1** to SW **4** regardless of the sequence of the buttons arranged on the upper case **10.**

As shown in **FIG.2B****,** connector patterns **460** and **470** are formed on the back side **401** of the circuit board **40.** The connector **46** is connected to the connector pattern **460** and the connector **47** is connected to the connector pattern **470.** The connector patterns **460** and **470** are electrically connected to the circuit board pattern **48** on the front side **400.** Thus, the extended-function unit **8** is electrically connected to the control circuit **51** of the control circuit unit **5** via the circuit board pattern **48** of the circuit board **40.**

Next, an example arrangement of switches will be described below.

### Arrangement of switches

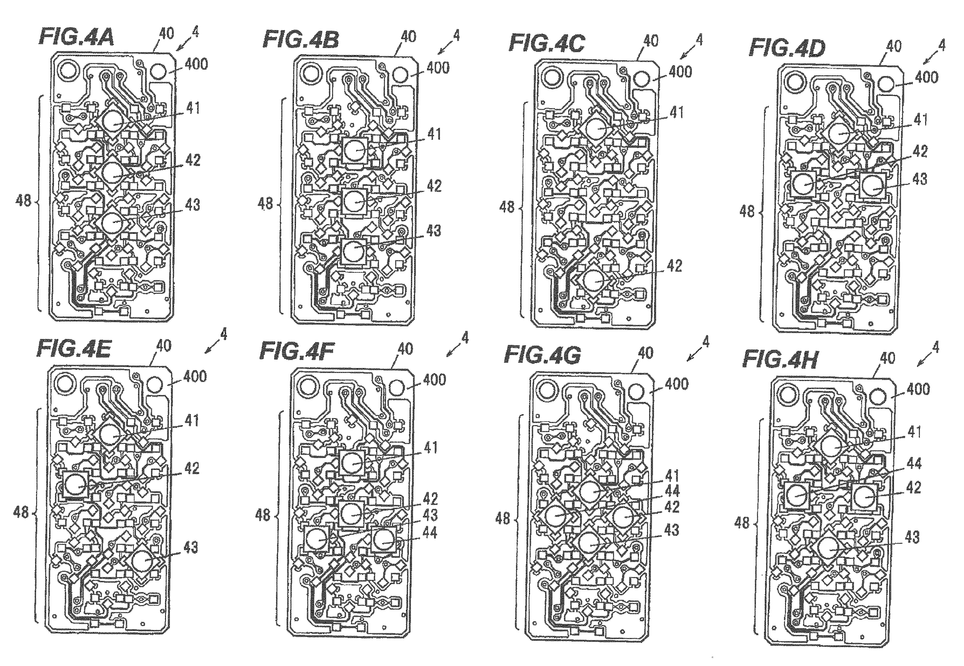

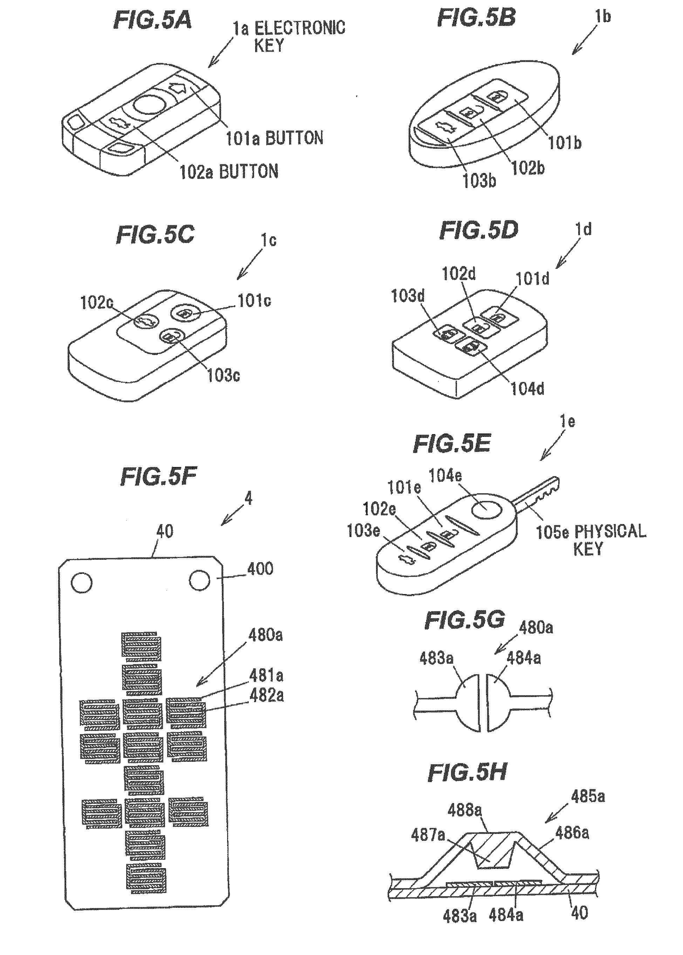

**FIGS.4A** to **4H** are schematic diagrams illustrating examples of arrangement of switches. **FIGS.5A** to **5E** are schematic diagrams illustrating examples of electronic keys with different designs, **FIG.5F** is a schematic diagram illustrating a modification of a circuit board pattern on the circuit board, **FIG.5G** is atop view showing another modification of the circuit board pattern and **FIG.5H** is a cross sectional view showing the main portion of a dome-shaped cover arranged on the circuit board.

On the circuit board **40** shown in **FIG.4A****,** three switches are arranged in line. In detail, the first switch **41** is mounted on the SW**1-1** mounting pattern **49** of the mounting pattern group **48a,** the second switch **42** is mounted on the SW**2-3** mounting pattern **49** of the mounting pattern group **48b,** and the third switch **43** is mounted on the SW**3-2** mounting pattern **49** of the mounting pattern group **48c.**

On the circuit board **40** shown in **FIG.4B****,** three switches are arranged in line in the similar manner. However, the arrangement thereof is different from that shown in **FIG.4A****.** In detail, the first switch **41** is mounted on the SW**2-3** mounting pattern **49** of the mounting pattern group **48b,** the second switch **42** is mounted on the SW**3-2** mounting pattern **49** of the mounting pattern group **48c,** and the third switch **43** is mounted on the SW**4-2** mounting pattern **49** of the mounting pattern group **48d.**

In **FIGS.5B** and **5E****,** electronic keys 1b and 1e designed to have three switches arranged as described above are shown as an example. However, the switches of the electronic keys **1b** and **1e** are mounted on the different mounting patterns **49** from those in **FIGS.4A** and **4B****.**

On the electronic key **1b** shown in **FIG.5B****,** buttons **101b** to **103b** are arranged, e.g., in line in a longitudinal direction. As an example, the electronic key **1b** is configured that the first switch **41** corresponding to the button **101b** is arranged on SW**1-1** of the circuit board pattern **48,** the second switch **42** corresponding to the button **102b** is arranged on SW**3-2** and the third switch **43** corresponding to the button **103b** is arranged on SW**2-4.**

The electronic key **1e** shown in **FIG.5E** has buttons **101e** to **103e** arranged in line, a push-button **104e** and a physical key **105e.** As an example, the switches corresponding to the buttons **101e** to **103e** are arrange on the same mounting patterns **49** as those in the electronic key **1b.** As an example, the physical key **105e** is pivotally ejected from the side of the case by depressing the push-button **104e** and is arranged between the module **2** and the case of the electronic key **1e.**

On the circuit board **40** shown in **FIG.4C****,** two switches are arranged in the longitudinal direction. In detail, the first switch **41** is mounted on the SW**1-1** mounting pattern **49** of the mounting pattern group **48a** and the second switch **42** is mounted on the SW**4-5** mounting pattern **49** of the mounting pattern group **48d.**

An electronic key **1a** shown in **FIG.5A** is an example of such an electronic key designed to have two switches arranged as described above.

On the electronic key **1a** shown in **FIG.5B****,** buttons **101a** and **102a** are, e.g., arranged apart in the longitudinal direction. As an example, the electronic key **1a** is configured that the first switch **41** corresponding to the button **101a** is arranged on SW**1-1** of the circuit board pattern **48,** and the second switch **42** corresponding to the button **102a** is arranged on SW**4-5.**

On the circuit board **40** shown in **FIG.4D****,** three switches are respectively arranged at the vertices of a triangle. In detail, the first switch **41** is mounted on the SW**1-1** mounting pattern **49** of the mounting pattern group **48a,** the second switch **42** is mounted on the SW**4-1** mounting pattern **49** of the mounting pattern group **48d,** and the third switch **43** is mounted on the SW**3-3** mounting pattern **49** of the mounting pattern group **48c.**

In **FIG.5C****,** an electronic key **1c** designed to have three switches arranged at the vertices of a triangle as described above is shown as an example.

On the electronic key **1c** shown in **FIG.5C****,** buttons **101c** to **103c** are arranged, e.g., at the vertices of a triangle. As an example, the electronic key **1c** is configured that the first switch **41** corresponding to the button **101c** is arranged on SW**1-1** of the circuit board pattern **48,** the second switch **42** corresponding to the button **102c** is arranged on SW**4-1** and the third switch **43** corresponding to the button **103c** is arranged on SW**3-3.**

On the circuit board **40** shown in **FIG.4E****,** the third switch **43** is arranged apart from the first switch **41** and the second switch **42,** as an example. In detail, the first switch **41** and the second switch **42** are mounted in the same arrangement as that shown in **FIG.4D** and the third switch **43** is mounted on the SW**2-5** mounting pattern **49** of the mounting pattern group **48b.**

On the circuit board **40** shown in **FIG.4F****,** four switches are arranged. In detail, the first switch **41** is mounted on the SW**2-3** mounting pattern **49** of the mounting pattern group **48b,** the second switch **42** is mounted on the **SW4-2** mounting pattern **49** of the mounting pattern group **48d,** the third switch **43** is mounted on the SW**3-4** mounting pattern **49** of the mounting pattern group **48c,** and the fourth switch **44** is mounted on the SW**1-4** mounting pattern **49** of the mounting pattern group **48a.**

In **FIG.5D****,** an electronic key **1d** designed to have four switches arranged as described above is shown as an example.

On the electronic key **1d** shown in **FIG.5D****,** for example, buttons **101d** and **102d** are arranged side by side in the longitudinal direction and buttons **103d** and **104d** are arranged side by side in the lateral direction. The buttons **103d** and **104d** are buttons to, e.g., open/close sliding doors on both sides of a vehicle and are arranged next to one another so as to correspond to the right and left sides of the vehicle.

As an example, the electronic key **1d** is configured that the first switch **41** corresponding to the button **101d** is arranged on SW**2-3** of the circuit board pattern **48,** the second switch **42** corresponding to the button **102d** is arranged on **SW4-2,** the third switch **43** corresponding to the button **103d** is arranged on SW**3-4,** and the fourth switch **44** corresponding to the button **104d** is arranged on SW**1-4.**

On the circuit board **40** shown in **FIG.4G****,** the four switches are respectively arranged at the ends of the arms of a cross. In detail, the first switch **41** is mounted on the SW**3-2** mounting pattern **49** of the mounting pattern group **48c,** the second switch **42** is mounted on the **SW4-3** mounting pattern **49** of the mounting pattern group **48d,** the third switch **43** is mounted on the SW**2-4** mounting pattern **49** of the mounting pattern group **48b,** and the fourth switch **44** is mounted on the SW**1-3** mounting pattern **49** of the mounting pattern group **48a.**

On the circuit board **40** shown in **FIG.4H****,** the four switches are respectively arranged at the ends of the arms of a different cross. In detail, the first switch **41** is mounted on the SW**1-1** mounting pattern **49** of the mounting pattern group **48a,** the second switch 4**2** is mounted on the SW**3-3** mounting pattern **49** of the mounting pattern group **48c,** the third switch **43** is mounted on the SW**2-4** mounting pattern **49** of the mounting pattern group **48b,** and the fourth switch **44** is mounted on the SW**4-1** mounting pattern **49** of the mounting pattern group **48d.**

As such, the circuit board **40** having plural mounting pattern groups as described above is widely adaptable to various switch arrangements.

Although the circuit board pattern **48** is configured so that switches are arranged thereon, it is not limited thereto. As a modification, the circuit board pattern **48** may be configured such that, e.g., a conductive member comes into contact with two terminals arranged on the circuit board **40** when a button is push-operated and the two terminals are electrically conducted through the member.

A circuit board pattern **480a** shown in **FIG.5F** is formed by arranging first and second terminals **481a** and **482a** having a comb shape to mesh with each other. In **FIG.5F****,** illustration of wiring, etc., electrically connected to the first and second terminals **481a** and **482a** is omitted.

As an another modification, the circuit board pattern **480a** shown in **FIG.5G** is provided with first and second terminals **483a** and **484a** having a semicircular shape which are arranged to face each other.

The circuit board pattern **480a** in the modifications functions as, e.g., a switch in combination with a dome-shaped cover **485a,** as shown in **FIG.5H****.** The dome-shaped cover **485a** has a hemispherical dome **486a** provided so as to correspond to the arrangement of the circuit board pattern **480a.** The dome-shaped cover **485a** is formed of, e.g., a resin such as silicone.

An upper surface **488a** of the dome **486a** comes into contact with a back side of a button of an electronic key. The dome **486a** also has a contact **487a** which is provided to face the first and second terminals **483a** and **484a.**

The contact **487a** has a conductivity Thus, when the dome **486a** is deformed by depressing the button, the contact **487a** comes into contact with the first and second terminals **483a** and **484a,** and the first terminal **483a** and the second terminal **484a** are thereby electrically conducted. After finishing the operation, the dome **486a** is restored to the original shape by a restoring force and electrical conduction between first and second terminals **483a** and **484a** is interrupted.

Also, when the dome-shaped cover **485a** is combined with the circuit board pattern **480a** shown in **FIG.5F****,** the contact **487a** comes into contact with the first and second terminals **481a** and **482a** by depression of the button, and the first terminal **481**a and the second terminal **482a** are electrically conducted through the contact **487a.**

### Configuration of control circuit unit 5

As shown in **FIG.1****,** the control circuit unit **5** is provided with the circuit board **50,** the control circuit **51,** the connector **52,** a first positive terminal **53,** a second positive terminal **54** and a negative terminal **55.**

The circuit board **50** is, e.g., a rectangular printed circuit board. The control circuit **51** and the connector **52** are arranged on an arrangement surface **500** of the circuit board **50.** Meanwhile, the first positive terminal **53,** the second positive terminal **54** and the negative terminal **55** are arranged on a terminal surface **501** which is a back side of the arrangement surface **500** of the circuit board **50.**

The control circuit **51** is composed of, e.g., a control unit including CPU (Central Processing Unit), etc., and a communication unit for wirelessly communicating with a vehicle, etc. The control circuit **51** is electrically connected to the first positive terminal **53,** the second positive terminal **54** and the negative terminal **55.** The control circuit **51** is also electrically connected to the connector **52.** In addition, the control circuit **51,** together with the receiving means mounted on the circuit board pattern **48,** forms an electronic circuit.

The first positive terminal **53,** the second positive terminal **54** and the negative terminal **55** are formed of, e.g., a conductive metal material such as copper, or an alloy material containing thereof, and is formed into a plate shape. Alternatively, the control circuit unit **5** may be provided with only one of the first positive terminal **53** and the second positive terminal **54,** or may be provided with a terminal having a shape formed by connecting the first positive terminal **53** to the second positive terminal **54**.

### Configuration of battery terminal 6

The battery terminal **6** is formed of, e.g., a conductive metal material such as copper, or an alloy material containing thereof.

As shown in **FIG.3E****,** the battery terminal **6** has a base portion **60** elongated in a direction intersecting with an insertion direction of the battery 7, first and second terminals **61** and **62** extending from both ends of the base portion **60** in a direction opposite to the insertion direction and coming into contact with one of the terminals of the inserted battery **7,** and curved portions **63** and **64** respectively provided on the first and second terminals **61** and **62** so as to curve toward the circuit board **50** and respectively coming into contact with the first positive terminal **53** to the second positive terminal **54** of the circuit board **50.**

The base portion **60** has a supporting portion **65** and guide portions **612** and **622.** The supporting portion **65** is provided at the center of the base portion **60** on a side surface on the first and second terminals **61** and **62** side. A portion protruding from the side surface of the base portion **60** is bend in the same direction as the curved portions **63** and **64** and the supporting portion **65** is thereby formed. The supporting portion **65** serves to, e.g., prevent deformation of the base portion **60** due to insertion of the battery **7,** etc.

As shown in **FIG.3E****,** an end portion of the base portion **60** on the first terminal **61** side is bent in the same direction as the curved portion **63** and the guide portion **612** is thereby formed. The guide portion **612** is inserted into the terminal holding groove **371** of the battery housing portion **37** on the wall **35** side.

As shown in **FIG.3E****,** an end portion of the base portion **60** on the second terminal **62** side is bent in the same direction as the curved portion **64** and the guide portion **622** is thereby formed. The guide portion **622** is inserted into the terminal holding groove **371** of the battery housing portion **37** on the front surface **33** side.

The first terminal **61** has the curved portion **63** on the base portion **60** side and a front end portion **611** on the opposite side. The first terminal **61** is also provided with the protruding portion **610** which protrudes in a direction opposite to the side to be in contact with the battery **7**.

The curved portion **63** is formed by bending a portion of the first terminal **61** on the base portion **60** side into a substantially oval shape. As shown in **FIG.3F**, when the control circuit unit **5,** the battery terminal **6** and the battery **7** are housed in the battery housing portion **37,** the curved portion **63** generates an elastic force due to deformation and comes into contact with the first positive terminal **53** of the circuit board **50.** Contact pressure between the curved portion **63** and the first positive terminal **53** is ensured by the elastic force.

Since the first terminal **61** is in contact with the positive terminal **70** of the inserted battery **7**, the first positive terminal **53** is electrically connected to the positive terminal **70** via the battery terminal **6.**

A lateral portion of the first terminal **61** on the inner side is bent at a position on the curved portion **63** side, and the protruding portion **610** is thereby formed. In more detail, the protruding portion **610** is formed by bending and lifting up a portion on the opposite side to the curved portion **63,** i.e., on the front end portion **611** side, toward the bottom surface **36** of the housing **3.**

The front end portion **611** is formed by bending an front end of the first terminal **61** in the same direction as the protruding portion **610.** The front end portion **611** is provided to facilitate insertion of the battery **7**.

The second terminal **62** has the curved portion **64** on the base portion **60** side and a front end portion **621** on the opposite side. The second terminal **62** is also provided with the protruding portion **620** which protrudes in a direction opposite to the side to be in contact with the battery **7.**

The curved portion **64** is formed by bending a portion of the second terminal **62** on the base portion **60** side into a substantially oval shape. As shown in **FIG.3F****,** when the control circuit unit **5,** the battery terminal **6** and the battery **7** are housed in the battery housing portion **37,** the curved portion **64** generates an elastic force due to deformation and comes into contact with the second positive **terminal 54** of the circuit board **50.** Contact pressure between the curved portion **64** and the second positive terminal **54** is ensured by the elastic force.

Since the second terminal **62** is in contact with the positive terminal **70** of the inserted battery **7,** the second positive terminal **54** is electrically connected to the positive terminal **70** via the battery terminal **6.**

A lateral portion of the second terminal **62** on the inner side is bent at a position on the curved portion **64** side, and the protruding portion **620** is thereby formed. In more detail, the protruding portion **620** is formed by bending and lifting up a portion on the opposite side to the curved portion **64,** i.e., on the front end portion **621** side, toward the bottom surface **36** of the housing **3**.

The front end portion **621** is formed by bending an front end of the second terminal **62** in the same direction as the protruding portion **620.** The front end portion **621** is provided to facilitate insertion of the battery **7** in the same manner as the front end portion **611.**

Next, how to assemble the control circuit unit **5**, the battery terminal **6** and the battery **7** will be described below.

### How to assemble battery terminal 6 etc_{.}

### Assembly of battery terminal 6

Firstly, the guide portions **612** and **622** of the battery terminal **6** are fitted to the terminal holding grooves **371** of the battery housing portion **37** of the housing **3** and the battery terminal **6** is then inserted into the battery housing portion **37,** thereby assembling the battery terminal **6** to the battery housing portion **37.**

In detail, when the guide portions **612** and **622** are inserted into the terminal holding grooves **371,** the guide portions **612** and **622** deform inward since a distance between the grooves is smaller than a distance between the guide portions **612** and **622.** Contact between the guide portions **612, 622** and the terminal holding grooves **371** is maintained by the deformation.

### Assembling of control circuit unit 5

Next, edges **502** and **503** of the circuit board **50** of the control circuit unit **5** are fitted into the circuit board holding grooves **372** of the battery housing portion **37,** thereby assembling the control circuit unit **5** to the battery housing portion **37.**

### Assembling of battery 7

Next, the battery **7** is inserted between the first and second terminals **61, 62** and the circuit board **50,** thereby assembling the battery **7** to the battery housing portion **37.**

In detail, when the battery **7** is inserted into the battery housing portion **37,** the perimeter portion of the battery **7** firstly comes into contact with the front end portion **611** of the first terminal **61** and the front end portion **621** of the second terminal **62,** and the battery **7** then pushes the first and second terminals **61** and **62** upward through the front end portions **611** and **621.** When the battery **7** is further inserted into the battery housing portion **37** and is then housed in the battery housing portion **37,** the first and second terminals **61** and **62** are further pushed up and the protruding portion **610** is fitted into the notched hole **361** and the protruding portion **620** into the notched hole **362,** as shown in **FIG.3F****.**

Also, when the battery **7** is housed in the battery housing portion **37,** the positive terminal **70** of the battery **7** comes into contact with the first terminal **61** as well as the second terminal **62** and the negative terminal **71** of the battery **7** comes into contact with the negative terminal **55** of the circuit board **50,** as shown in **FIG.3F****.** The battery **7** is sandwiched between the first and second terminals **61, 62** and the circuit board **50,** and an elastic force of the first and second terminals **61** and **62** maintains contact of the first and second terminals **61** and **62** with the positive terminal **70** and contact of the negative terminal **71** with the negative terminal **55.**

Once assembled, the positive terminal **70** of the battery **7** is electrically connected to the first positive terminal **53** and the second positive terminal **54** of the circuit board **50** via the battery terminal **6,** the negative terminal **71** of the battery **7** is electrically connected to the negative terminal **55** of the circuit board **50,** and the battery **7** is thus electrically connected to the control circuit **51.**

### Effects of the embodiment

The electronic key **1** in the present embodiment is flexibly adaptable to a change in the design. In detail, since the interface unit **4** provided with the first to fourth switches **41** to **44** and the control circuit unit **5** provided with the control circuit **51** are formed on the separate circuit boards in the electronic key **1,** the electronic key **1** can be adapted to a different electronic key design by changing, e.g., the positions of the switches of the interface unit **4.** Since the circuit board **40** of the interface unit **4** allows a switch to be arranged on any mounting pattern **49** of a mounting pattern group, it is possible to flexibly change the arrangement of switches by providing plural mounting pattern groups. Therefore, the electronic key 1 is more flexibly adaptable to a change in the design than an electronic key in which a receiving means for receiving an operation and a control unit are provided on the same circuit board.

Since, in the electronic key **1,** the interface unit **4** is independent from the control circuit unit **5** and also the switches can be arranged flexibly, it is not necessary to change the pattern for every electronic key design. This means that the electronic key **1** can be manufactured at low cost since redesign and evaluation of the circuit board pattern **48** due to a change in a switch position or a change in a wiring position based on high-frequency characteristics are not required and it is adaptable to plural designs while using the same circuit board **40.** In addition, it is easy to change the specification of the electronic key **1** since the circuit board **40** of the interface unit **4** can be exchanged with a circuit board having a different function without changing the circuit board **50** of the control circuit unit **5** having a control function.

Since each signal line is shared by multiple pads in the circuit board **40** of the interface unit **4,** the arrangement of the receiving means, etc., can be varied by changing a program of the control circuit unit **5** associated with installation of the receiving means.

Since the extended-function unit **8** is exchangeable, the electronic key **1** can be flexibly used as an electronic key having a different specification.

In the electronic key **1,** the extended-function unit **8** is electrically connected to the control circuit **51** of the control circuit unit **5** via the circuit board **40** of the interface unit **4.** In other words, the circuit board **40** is electrically connected to the control circuit unit **5** via the connector **46** and is electrically connected to the extended-function unit **8** via the connector **47.**

Although the embodiment and some modifications of the invention have been described, the embodiment and modifications are merely an example and the invention according to claims is not to be limited thereto. These new embodiment and modifications may be implemented in various other forms, and various omissions, substitutions and changes, etc., can be made without departing from the gist of the invention. In addition, all combinations of the features described in the embodiment and modifications are not necessary to solve the problem of the invention. Further, the embodiment and modifications thereof are included within the scope and gist of the invention and also within the invention described in the claims and the range of equivalency.

## Claims

1. A circuit board, comprising a circuit board pattern forming a part of an electronic circuit and comprising a mounting pattern group on which a receiving means for receiving an operation can be mounted,
wherein the electronic circuit is established even when the receiving means is mounted on any mounting pattern of the mounting pattern group.

2. The circuit board according to claim 1, wherein the mounting pattern group comprises a plurality of mounting pattern groups.

3. The circuit board according to claim 2, wherein one terminal is commonly used between the mounting patterns belonging to same one of the mounting pattern group.

4. The circuit board according to one of the preceding claims, further comprising a connector electrically connected to a control circuit board comprising a control circuit of the electronic circuit.

5. An electronic key, comprising the circuit board according to one of the preceding claims.

6. The circuit board according to one of claims 2 to 4, wherein another terminal is commonly used between the mounting patterns belonging to different one of the mounting pattern groups.

7. The circuit board according to one of claims 2 to 4, wherein the mounting pattern groups are separately and electrically connected to a control circuit board comprising a control circuit of the electronic circuit.

8. The circuit board according to one of claims 2 to 4, wherein the mounting pattern groups are arranged in a pattern different from each other.
